# EUROPÄISCHE PATENTANMELDUNG

(11) **EP 0 998 042 A2**
(43) Veröffentlichungstag der Anmeldung: **03.05.2000**
(21) Anmeldenummer: 99120159.1
(22) Anmeldetag: 08.10.1999
(51) Int. Cl.: H03K 17/945

(54) **Berührungslos arbeitendes Schaltgerät mit einem Sensorkopf**

(30) Priorität: 20.10.1998 DE 19848288
(71) Anmelder: SIEMENS AKTIENGESELLSCHAFT, 80333 München (DE)
(72) Erfinder: List, Konrad, 92237 Sulzbach-Rosenberg (DE); Eckert, Anton, 92249 Vilseck (DE)

(57) **Zusammenfassung**

Ein Sensorkopf (1) und ein zur Halterung dienendes Unterteil (5) sind über Verdrehflächen (9,15) und einem Aufnahmedorn (10) drehbeweglich zusammengefügt. Erfindungsgemäß ist der Aufnahmedorn an der Verdrehfläche (9) des Sensorkopfes (1) mit einer umlaufenden Nut (12) versehen, in die Gewindestifte (20) am Unterteil (5) zur gegenseitigen Fixierung einschraubbar sind. Die Verdrehflächen (9,15) weisen gegenüber einem zylinderförmigen Ansatzes (7) am Unterteil (5) einen Neigungswinkel von 45° auf.

## Beschreibung

Die Erfindung betrifft ein berührungslos arbeitendes Schaltgerät mit einem Sensorkopf und einem Unterteil, wobei der Sensorkopf und das Unterteil durch einen Aufnahmedorn drehbeweglich verbunden sind, wozu der Aufnahmedorn an einer ersten Verdrehfläche des Sensorkopfes vorgesehen ist, der in eine paßgenaue Öffnung in einer zweiten Verdrehfläche des Unterteils eingreift.

Ein gattungsgemäßes Schaltgerät ist in der DE 78 11 803 U offenbart. Der Sensorkopf besitzt hier an der dem Unterteil zugeordneten Seite einen Arretierungsstift, dem mehrere Arretierungsbohrungen am Unterteil zugeordnet sind. Die Zahl der Arretierungsbohrungen richtet sich nach den verschiedenen Winkelstellungen des Sensorkopfes. Als Begrenzung des Verschiebeweges des Sensorkopfes ist eine am Ende des Aufnahmedorns gelagerte Stern- oder Tellerfeder befestigt, die sich unter Vorspannung an die Innenseite des Unterteils abstützt. Damit ist eine Verschiebung des Sensorkopfes nur entgegen der Federwirkung möglich, wobei der Federkopf in der gewünschten Winkelstellung selbsttätig in die Arretierungsbohrung einrastet.

Der Erfindung liegt die Aufgabe zugrunde, ein berührungslos arbeitendes Schaltgerät der obengenannten Art dahingehend zu verbessern, daß die Ausrichtung des Sensorkopfes in beliebige Stellungen, d.h. insbesondere stufenlos, möglich ist.

Die Aufgabe wird dadurch gelöst, daß der Aufnahmedorn an seiner Umfangsfläche eine umlaufende Nut aufweist, und daß das Unterteil mindestens eine in die Öffnung reichende Gewindebohrung an solcher Stelle aufweist, daß die Gewindebohrung der Nut in verschiedenen Verdrehstellungen gegenüber steht und daß der Sensorkopf mittels eines Gewindestifts über die Gewindebohrung durch Eingreifen in die Nut feststellbar ist. Dabei ermöglicht die Nut eine Verdrehung in beliebige Positionen, d.h. über den gesamten Winkelbereich von 360°, sofern die Nut über den gesamten Umfang ausgeführt ist. Zugleich dient die Nut zur Arretierung in einer bestimmten Stellung. Hierzu wird ein Gewindestift in die Nut eingeschraubt.

Vorteilhafte Weiterbildungen der Erfindung sind den folgenden Unteransprüchen zu entnehmen.

Weist das Unterteil einen zylindrischen Ansatz auf, über den das Unterteil in einer Halterung drehbar gelagert ist, und weist die zweite Drehfläche gegenüber der Zylinderachse des symmetrischen Ansatzes einen von 90° abweichenden Neigungswinkel auf, so wird hierdurch die Ausrichtung des Sensorkopfes in einen vom Neigungswinkel abhängigen, mehr oder weniger weiten Bereich ermöglicht.

Besonders vorteilhaft ist es, wenn der Neigungswinkel 45° beträgt, da hierbei der Sensorkopf an jede beliebige Stelle eines Halbraums ausgerichtet werden kann.

Eine besonders einfache und zugleich zuverlässige Halterung ist gegeben, wenn der zylindrische Ansatz einen zumindest teilweise kreisförmigen Aufnahmekragen aufweist, über den das Unterteil mittels Klemmbacken in verschiedenen Drehstellungen an der Halterung feststellbar ist.

Eine besonders vorteilhafte Ausführungsform ergibt sich, wenn die Nut schrägflächig, insbesondere als V- oder Ringnut ausgeführt ist, da hierdurch der Sensorkopf in die Öffnung des Unterteils hineingezogen wird und dadurch die Klemmwirkung verbessert wird.

Um eine Verdrehsicherung zwischen dem Sensorkopf und dem Unterteil zu erreichen, greift ein aus der ersten Verdrehfläche vorragender erster Stift in eine zur Drehachse zwischen Sensorkopf und Unterteil symmetrisch in die zweite Verdrehfläche eingearbeitete Kreisnut ein, die nicht über den gesamten Umfang ausgeführt ist.

Weist das Unterteil an seinem Aufnahmekragen einen zweiten Stift auf, der in eine Kreisnut der Halterung eingreift, die nicht über den gesamten Umfang ausgeführt ist, so wird auch hier eine Verdrehsicherung gewährleistet, durch die eine Beschädigung der durch das Schaltgerät hindurchgeführten Verbindungsleitungen vermieden wird.

Ein Ausführungsbeispiel der Erfindung wird im folgenden anhand einer Zeichnung näher erläutert. Es zeigen:
- FIG 1: eine Darstellung eines erfindungsgemäßen Sensorkopfes im zusammengebauten, mit einer Halterung verbundenen Zustand,
- FIG 2: eine Explosionsdarstellung des erfindungsgemäßen Sensorkopfes mit der Halterung,
- FIG 3: ein Unterteil des Sensorkopfes.

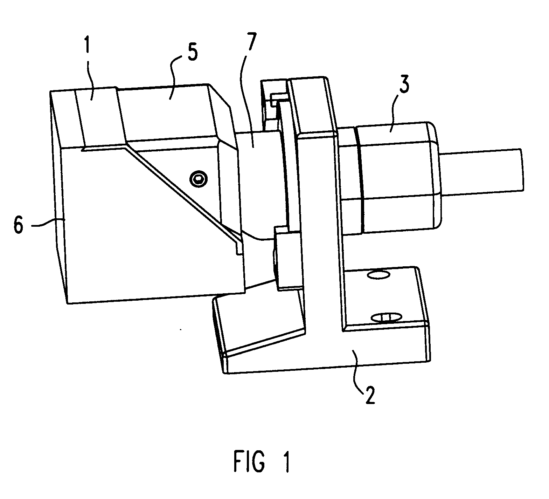

In FIG 1 ist der komplett zusammengebaute erfindungsgemäße Sensorkopf 1 mit einer zugehörigen Halterung 2 und einem Kabelanschluß 3 dargestellt. Der Sensorkopf 1 bildet zusammen mit einem Unterteil 5 einen Quader. Der Sensorkopf 1 und das Unterteil 5 sind über schräge Verdrehflächen aneinandergefügt, die gegenüber der Sensorfrontfläche 6 am Sensorkopf 1 einen Winkel von 45° aufweisen. Das Unterteil 5 ist mit einem zylinderförmigen Ansatz 7 versehen, über den die Halterung 2 des Sensorkopfes 1 erfolgt und dessen Zylinderachse senkrecht zur Sensorfrontfläche 6 steht und in einem Neigungswinkel von 45° zu den Verdrehflächen steht.

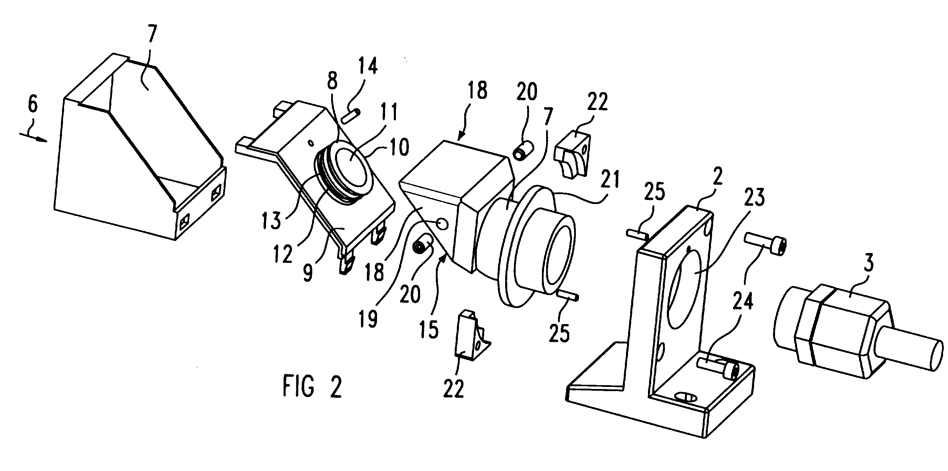

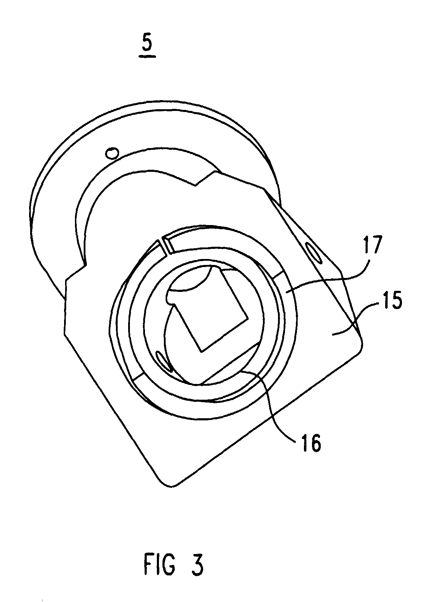

Die wesentlichen Komponenten des Sensorkopfes 1 des Unterteils 5 und der zugehörigen Halterung 2 sind in einer Explosionsdarstellung gemäß FIG 2 dargestellt. Der Sensorkopf 1 ist aus einem Sensorkopfgehäuse 7 und einem mit diesem verrastbaren Kopfeinsatz 8 gebildet. Das Sensorkopfgehäuse 7 weist auf seiner einen Seite die Sensorfrontfläche 6 auf und dieser abgewandt und in einem Winkel von 45° zu dieser stehend ist eine durch den Kopfeinsatz 8 gebildete Verdrehfläche 9 vorgesehen. In der Mitte der Verdrehfläche 9 ist ein Aufnahmedorn 10 mit einer Durchgangsöffnung 11 angeordnet. Der zylindrisch geformte Aufnahmedorn 10 weist an seiner Umfangsfläche eine erste Nut 12 zur nachfolgend beschriebenen Fixierung und eine zweite Nut 13 mit einem hier nicht dargestellten Dichtungsring auf. Die Verdrehfläche 9 ist an geeigneter Stelle mit einem Stift 14 versehen. Das Unterteil 5 weist eine der Verdrehfläche 9 angepaßte Verdrehfläche 15 auf, die eine Öffnung 16 gemäß FIG 3 besitzt. Die Verdrehfläche 15 steht in einem Neigungswinkel von 45° gegenüber dem zylinderförmigen Ansatz 7 des Unterteils 5. Allerdings sind auch kleinere Neigungswinkel denkbar. Die kreisrunde Öffnung 16 im Unterteil 5 ist in ihrer Größe und Ausführung zur Aufnahme des Autnahmedorns 10 diesem angepaßt. Um die kreisförmige Öffnung 16 herum ist eine ringförmige Nut 17 vorgesehen, die an einer Stelle unterbrochen ist.

An den zur Verdrehfläche 15 angrenzenden Seitenflächen 18 des Unterteils 5 ist jeweils eine Gewindebohrung 19 zur Aufnahme eines Gewindestiftes 20 vorgesehen. Die Gewindebohrungen 19 sind derart positioniert, daß sie nach Zusammenfügung des Sensorkopfes 1 mit dem Unterteil 5 der Nut 12 am Aufnahmedorn 10 gegenüberstehen. Der zylinderförmige Ansatz 7 weist einen ringförmigen Aufnahmekragen 21 auf, über den der Sensorkopt 1 mittels zweier Klemmbacken 22 an der Halterung 2 verdrehbar gelagert werden kann. Das Unterteil 5 wird hierzu mit seinem zylinderförmigen Ansatz 7 in eine entsprechend ausgeführte Öffnung 23 von der einen Seite in die Halterung 2 eingeführt. Mit Klemmschrauben 24 wird der Aufnahmekragen 21 des Unterteils 5 über die Klemmbacken 22 und damit an die Halterung 2 gedrückt. Der Kabelanschluß 3 wird von der anderen Seite der Halterung 2 in die Öffnung 23 geschoben.

Der Sensorkopf 1 ist über den zylinderförmigen Ansatz 7 um nahezu 360° drehbar. Um eine Beschädigung des vom Sensorkopf 1 zum Kabelanschluß 3 verlaufenden Kabels zu vermeiden, kann mittels eines Stiftes 25 im Aufnahmekragen 21, der in eine hier nicht dargestellte, entsprechend liegende Kreisnut in der Halterung 2 eingreift, ein Verdrehschutz ausgeführt werden. In Verbindung mit dieser Verdrehbarkeit wird die Ausrichtung der Sensorfrontfläche 6 in jede beliebige Richtung des Halbraumes vor dem Halter 2 dadurch ermöglicht, daß eine Verdrehung über die Verdrehflächen 9 und 15 zwischen dem Sensorkopf 1 und dem Unterteil 5 möglich ist. Die Halterung und Fixierung zwischen beiden Komponenten erfolgt hier über den Aufnahmedorn 10 und die Gewindestiften 20, die zur Fixierung in die Nut 12 des Aufnahmedorns 10 eingeschraubt werden.

Im Sensorkopfgehäuse 7 ist üblicherweise ein Sensor und eine mit ihm verbundene Elektronik untergebracht, von der ein Kabel durch die Durchgangsöffnung 11 und den zylinderförmigen Ansatz 7 bis hin zum Kabelanschluß 3 geführt wird. Der aus der Verdrehfläche 9 herausragende Stift 14 greift im zusammenmontierten Zustand des Sensorkopfes 1 in die nicht völlig umlaufende Ringnut 17 ein, wodurch hier ebenfalls eine Verdrehsicherung erreicht wird. Die Ausführung der Nut 12 erfolgt schrägflächig, z.B. als V- oder Rundnut, um eine bessere Klemmwirkung zu erreichen, bei der der Sensorkopf 1 in die Öffnung 16 des Unterteils 5 hineingezogen wird.

## Patentansprüche

1. Berührungslos arbeitendes Schaltgerät mit einem Sensorkopf (1) und einem Unterteil (5), wobei der Sensorkopf (1) und das Unterteil (5) durch einen Aufnahmedorn (10) drehbeweglich verbunden sind, wozu der Aufnahmedorn (10) an einer ersten Verdrehfläche (9) des Sensorkopfes (1) vorgesehen ist, der in eine paßgenaue Öffnung (16) in einer zweiten Verdrehfläche (15) des Unterteils (5) eingreift, **dadurch gekennzeichnet,** daß der Aufnahmedorn (10) an seiner Umfangsfläche eine umlaufende Nut (12) aufweist, und daß das Unterteil (5) mindestens eine in die Öffnung (16) reichende Gewindebohrung (19) an solcher Stelle aufweist, daß die Gewindebohrung (19) der Nut (12) in verschiedenen Verdrehstellungen gegenüber steht, und daß der Sensorkopf (1) mittels eines Gewindestifts (20) über die Gewindebohrung (19) durch Eingreifen in die Nut (12) feststellbar ist.

2. Berührungslos arbeitendes Schaltgerät nach Anspruch 1, **dadurch gekennzeichnet,** daß das Unterteil (5) einen zylindrischen Ansatz (7) aufweist, über den das Unterteil (5) in einer Halterung (2) drehbar gelagert ist, und daß die zweite Verdrehfläche (15) gegenüber der Zylinderachse des symmetrischen Ansatzes (7) einen von 90° abweichenden Neigungswinkel aufweist.

3. Berührungslos arbeitendes Schaltgerät nach Anspruch 2, **dadurch gekennzeichnet,** daß der Neigungswinkel 45° beträgt.

4. Berührungslos arbeitendes Schaltgerät nach Anspruch 2 oder 3, **dadurch gekennzeichnet,** daß der zylindrische Ansatz (7) einen zumindest teilweise kreisförmigen Aufnahmekragen (21) aufweist, über den das Unterteil (5) mittels Klemmbacken (22) in verschiedenen Drehstellungen an der Halterung (2) feststellbar ist.

5. Berührungslos arbeitendes Schaltgerät nach einem der vorangehenden Ansprüche, **dadurch gekennzeichnet,** daß die Nut (12) schrägflächig, insbesondere als V- oder Ringnut, ausgeführt ist.

6. Berührungslos arbeitendes Schaltgerät nach einem der vorangehenden Ansprüche, **dadurch gekennzeichnet,** daß ein aus der ersten Verdrehfläche (9) vorragender erster Stift (14) in eine zur Drehachse zwischen Sensorkopf (1) und Unterteil (5) symmetrisch, in die zweite Verdrehfläche (15) eingearbeitete Kreisnut (17) eingreift, die nicht über den gesamten Umfang ausgeführt ist.

7. Berührungslos arbeitendes Schaltgerät nach einem der vorangehenden Ansprüche, **dadurch gekennzeichnet,** daß das Unterteil (5) an seinem Aufnahmekragen (21) einen zweiten Stift (25) aufweist, der in eine Kreisnut der Halterung (2) eingreift, die nicht über den gesamten Umfang ausgeführt ist.
